# EUROPEAN PATENT APPLICATION

(11) **EP 1 538 831 A1**
(43) Date of publication of application: **08.06.2005**
(21) Application number: 04028144.6
(22) Date of filing: 26.11.2004
(51) Int. Cl.: H04N 5/44

(54) **Channel selecting unit**

(30) Priority: 01.12.2003 JP 2003400992
(71) Applicant: ORION ELECTRIC CO., Ltd., Takefu-City, Fukui 915-8555 (JP)
(72) Inventor: Tsubokawa, Yukio, c/o Orion Electric Co., Ltd., Takefu-city Fukui 915-8555 (JP)
(74) Representative: Goddar, Heinz J., Dr.

(57) **Abstract**

It is an object of the invention to provide a channel selecting unit capable of implementing a channel selecting operation accurately in a short time with a simple circuit configuration. AFT voltages from a tuner 10 of a picture recording and playback portion 1 and a tuner 20 of a receiver portion 2 are detected by an AFT voltage detecting portion 30, while a synchronous signal separated at a video information processing portion 13 of the picture recording and playback portion 1 is counted by a pulse counter 31 and the presence or absence of synchronization is detected by a synchronization detecting potion 33. A channel selecting portion 32 transmits a tuning instruction signal to the tuner 10 and allows tuning frequency data f₁ and an AFT voltage value V₀, at the time when synchronization was detected, to be stored in a storage portion 4, thereby implementing the channel selecting operation based on stored data at the time of channel select processing of the tuner 20.

## Description

### FIELD OF THE INVENTION

The invention relates to a channel selecting unit in electronic equipment provided with a tuner such as a TV (television) receiver, a VTR (Video Tape Recorder) having a built-in tuner, and the like.

### BACKGROUND OF THE INVENTION

Since an environment for receiving waves varies depending on its installing site in electronic equipment such as a TV receiver and the like, it is necessary to implement tuning operation for every electronic equipment. Such a tuning operation has to be implemented for every channel, which takes much time, and hence there is proposed an automatic tuning method.

For example, there is disclosed in JP 7-7391A that in an automatic search tuning system for automatically deciding a tuning point based on a synchronous signal of a received TV signal and an AFT signal by automatically varying a tuning voltage to be applied to a turner, a plurality of standard values for deciding the presence or absence of the synchronous signal are provided, which standard values can be selected by operating a switching key Further, there is disclosed in JP 2001-119643A that in the case where a received frequency is changed by varying a channel selecting voltage of a tuner based on a channel switching instruction, a microcomputer confirms stability of anAGC voltage and an AFT voltage, then checks as to whether the AFT voltage is the same as a standard voltage value or not, and retains a receiving state at that time, thereby ending a channel selecting operation. Still further, there is disclosed in JP 2003-179824A that in the case where a synchronization detecting signal outputted from a video recorder represents the presence of a synchronous signal, a value of an IF-AGC voltage generated in a tuner and channel information instructed by a tuning instruction signal are allowed to correspond to each other and stored.

In the above-mentioned references, since a channel selecting operation is implemented by detecting the presence or absence of the synchronous signal of a TV signal, it takes time by the time needed for detecting the presence or absence of the synchronous signal every time the channel selecting operation is implemented. In the case of equipment capable of recording picture by another channel while viewing a TV program, it is necessary to provide a plurality of tuners so that a circuit for detecting the presence or absence of the synchronous signal has to be provided for every tuner.

Further, in the case where the channel selecting operation is implemented by use of the AGC voltage, the AGC voltage is prone to vary owing to an external factor and is unstable, which renders an accurate channel selecting operation difficult.

### SUMMARY OF THE INVENTION

It is therefore an object of the invention to provide a channel selecting unit capable of implementing a channel selecting operation accurately in a short time with a simple circuit configuration.

To achieve the above object, the channel selecting unit according to one aspect of the invention is characterized in comprising a tuner for outputting an intermediate frequency based on a tuning instruction signal corresponding to a channel, a VIF circuit for amplifying the intermediate frequency signal outputted from the tuner and outputting an AFT voltage, a video signal processing circuit for separating a synchronous signal from the amplified intermediately frequency signal outputted from the VIF circuit and outputting the synchronous signal, and a control circuit for outputting the tuning instruction signal to the tuner and subjecting the tuner to an AFT control based on the AFT voltage, wherein the control circuit is comprised of synchronization detecting means for detecting the presence or absence of synchronization based on the synchronous signal, storage means for storing therein tuning frequency data and an AFT voltage value for every channel when the synchronization detecting means detects the presence of synchronization and the AFT voltage falling within a predetermined range, and channel select control means for reading out the tuning frequency data and the AFT voltage value of a pertinent turner from the storage means based on a channel switching signal, thereby implementing a channel selecting operation.

The channel selecting unit according to another aspect of the invention is characterized in comprising a plurality of tuners each outputting an intermediate frequency based on a tuning instruction signal corresponding to a channel, a plurality of VIF circuits each amplifying an intermediate frequency signal outputted from each tuner and outputting an AFT voltage, a video signal processing circuit for separating a synchronous signal from the amplified intermediate frequency signal outputted from each VIF circuit and outputting the synchronous signal, and a control circuit for outputting the tuning instruction signal to each tuner and subjecting each tuner to an AFT control based on the AFT voltage, wherein the control circuit is comprised of synchronization detecting means for detecting the presence or absence of synchronization based on the synchronous signal which is separated from the intermediate frequency signal outputted from a specified tuner, storage means for storing therein tuning frequency data and an AFT voltage value for every channel when the synchronization detecting means detects the presence of synchronization and the AFT voltage falling within a predetermined range, and channel select control means for reading out the tuning frequency data and the AFT voltage value of the pertinent tuner from the storage means based on a channel switching signal relating to a tuner other than the specified tuner, thereby implementing a channel selecting operation. Further, the specified tuner is characterized to be a tuner for recording picture.

With the above-mentioned channel selecting unit, the channel select control means is characterized in implementing the channel selecting operation until the AFT voltage reaches a predetermined range by controlling the frequency in such a manner that it gradually increases the frequency beginning with frequency data which is lower than the tuning frequency data read out from the storage means by a predetermined frequency.

With the channel selecting unit having the above mentioned configuration, since the tuning frequency data and the AFT voltage value are stored for every channel when the synchronization detecting means detects the presence of synchronization and the AFT voltage falling within the predetermined range, and the tuning frequency data and the AFT voltage value of the pertinent channel are read out from the storage means when the channel is subsequently switched, thereby implementing the channel selecting operation. Accordingly, once the tuning frequency data and the AFT voltage value are stored in the storage means for every channel, the channel selecting operation can be implemented without detecting synchronization so that the channel selecting operation can be implemented in a short time. Further, since the channel selecting operation is implemented by use of the AFT voltage value which is not susceptible to an external factor, a stable and accurate channel selecting operation can be implemented.

In the channel selecting unit provided with a plurality of tuners, at the time when the synchronization detecting means detects the presence of synchronization relative to a specified tuner and the AFT voltage falling within the predetermined range, the tuning frequency data and the AFT voltage value are stored in the storage means for every channel, while at the time of switching of the channel relative to the tuner other than the specified tuner, the tuning frequency data and the AFT voltage value of the pertinent channel are read out from the storage means, thereby implementing the channel selecting operation, so that the detection of synchronization relative to the tuner other than the specified tuner is not needed, thereby dispensing with the synchronization detecting circuit and the detection processing. Accordingly, the circuit configuration and the process can be simplified, and an accurate channel selecting operation can be implemented in a short time.

If the specified tuner is a tuner for recording picture, a channel selecting operation of the tuner for viewing can be implemented by use of tuning frequency data and an AFT voltage value which are determined by the tuner for recording picture, so that the channel selecting operation by the tuner for viewing can be implemented in a short time, thereby simplifying the circuit configuration and downsizing the channel selecting unit per se.

Further, since the channel select control means implements the channel selecting operation until the AFT voltage reaches a predetermined range by controlling the frequency in such a manner that it gradually increases the frequency beginning with frequency data which is lower than the tuning frequency data read out from the storage means by a predetermined frequency, even if the actual tuning frequency is deviated from the stored data, the channel selecting operation can be surely implemented.

### BRIEF DESCRIPTION OF THE DRAWINGS

Fig. 1 is a block diagram of a video display unit employing the embodiment of the invention;
Fig. 2 is a flowchart showing processes in a preset operation;
Fig. 3 is a flowchart showing processes in a channel select processing; and
Fig. 4 is a graph showing a relationship between an AFT voltage and a frequency.

### PREFERRED EMBODIMENT OF THE INVENTION

The channel selecting unit of the invention according to the embodiment of the invention is now described more in detail. Since the working example described hereinafter is a preferable concrete example for working out the invention, it is limited variously technically, but the invention is not limited to the working example unless explicitly limiting the invention to the working example.

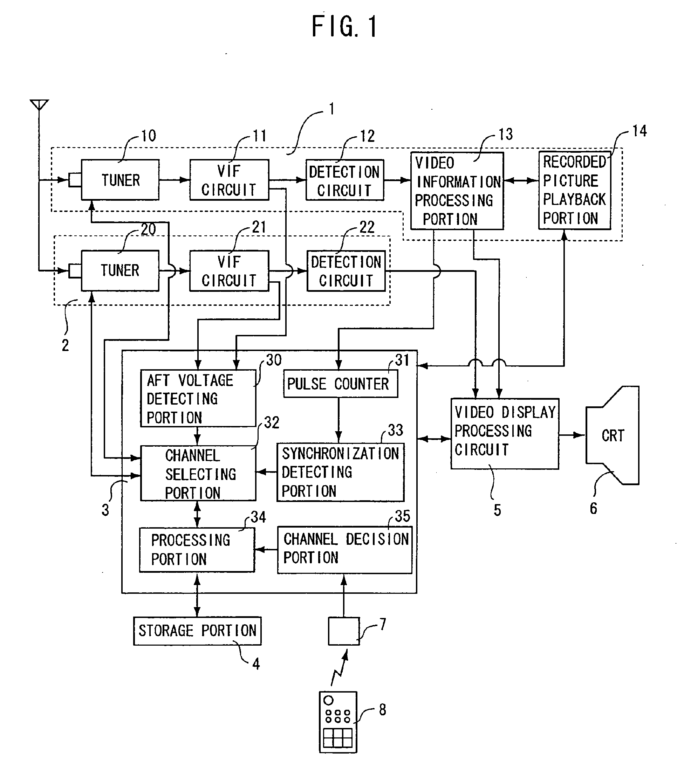

Fig. 1 is an entire block diagram of a video display unit provided with the embodiment of the invention. The video display unit comprises a picture recording and playback portion 1 for recording a picture and play backing the recorded picture upon reception of a TV broadcast signal, a receiver portion 2 for viewing a TV broadcast program, a control portion 3 for controlling the entire video display unit, a storage portion 4 for storing a program and data necessary for implementing the control, a video display processing circuit 5 for implementing a process in such a manner that it receives a video signal from the picture recording and playback portion 1 or the receiver portion 2 and displays the video signal on a CRT 6, and an operation information input portion 7 for receiving an operation signal issued by a remote controller 8 when an operator operates the remote controller 8.

The picture recording and playback portion 1 is comprised of a tuner 10 for amplifying a frequency signal of an intended channel from a TV broadcast signal received by an antenna to output it as an intermediate frequency signal (frequency is 58.75 MHz), a VIF circuit 11 connected to the tuner 10 for amplifying the intermediate frequency signal, a detection circuit 12 connected to the VIF circuit 11 for fetching a video signal from the intermediate frequency signal, and a video information processing portion 13 connected to the detection circuit 12 for processing the video signal to output the processed video signal to a recorded picture playback portion 14. The VIF circuit 11 outputs an AFT voltage necessary for keeping an oscillation frequency of the tuner 10 in a stable state to the control portion 3, and the video information processing portion 13 receives video information which is play backed by the recorded picture playback portion 14 and transmits it to the video display processing circuit 5, and also separates a synchronous signal from the video signal and outputs it to the control portion 3.

The receiver portion 2 is comprised of a tuner 20, a VIF circuit 21 and a detection circuit 22 like the tuner 10, the VIF circuit 11 and the detection circuit 12, respectively, of the picture recording and playback portion 1, wherein a video signal outputted from the detection circuit 22 is to be inputted to the video display processing circuit 5.

The control portion 3 is comprised of an AFT voltage detecting portion 30 for receiving the AFT voltages outputted from the VIF circuit 11 and the VIF circuit 21, a pulse counter 31 for counting the synchronous signal upon reception of the same synchronous signal outputted from the video information processing portion 13, a synchronization detecting potion 33 for detecting the presence or absence of synchronization based on a counted value of the pulse counter 31, a channel selecting portion 32 for outputting a tuning instruction signal corresponding to a selected channel to the tuner 10 or the tuner 20, and receiving detection signals from the AFT voltage detecting portion 30 and the synchronization detecting potion 33, thereby controlling the tuner to implement a channel selecting operation, a channel decision portion 35 for deciding a channel upon reception of the operation signal outputted from the operation information input portion 7, and a processing portion 34 for outputting information needed for selecting the channel to the channel selecting portion 32, and allowing the tuning frequency data and the AFT voltage value outputted from the channel selecting portion 32 to be stored in the storage portion 4 together with channel information.

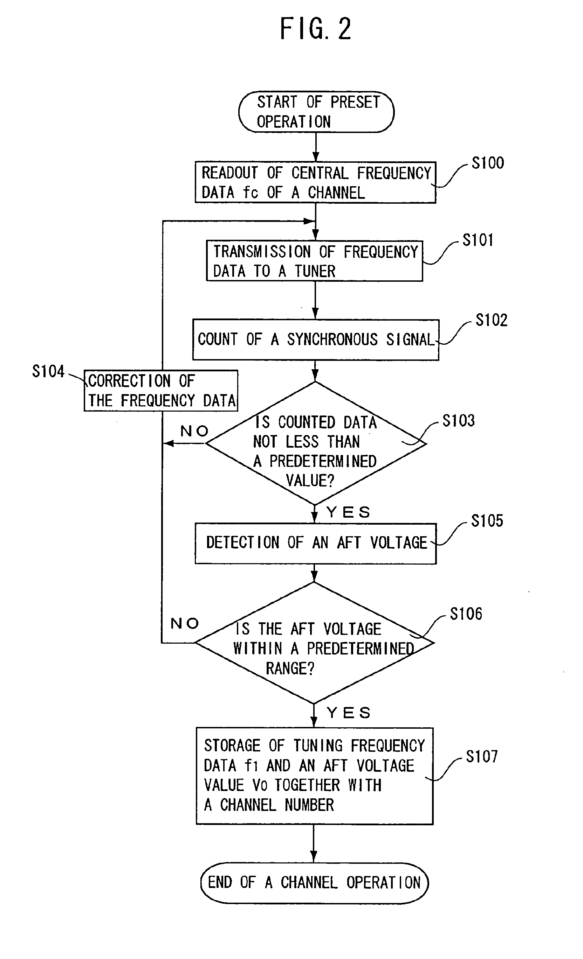

Fig. 2 is a flowchart showing processes of a preset operation for implementing the channel selecting operation first. When the preset operation is started, central frequency data f_{c} of one channel is first read out (S100). Central frequencies of respective channels are predetermined and the central frequencies of all the channels are stored in the storage portion 4 as a data table. Then, for example, a central frequency (93MHz) of the first channel is read out by the processing portion 34. Subsequently, the processing portion 34 transmits the readout central frequency data to the channel selecting portion 32, and the channel selecting portion 32 transmits a tuning instruction signal to the tuner 10 based on the same data (S101).

The tuner 10 amplifies the pertinent central frequency signal based on the tuning instruction signal and outputs an intermediate frequency signal to the VIF circuit 11, and the signal is transmitted from the VIF circuit 11 to the video information processing portion 13 through the detection circuit 12, while the synchronous signal is separated in the video information processing portion 13, and it is inputted to the pulse counter 31 (S102). The pulse counter 31 counts, for example, a horizontal synchronous signal and the synchronization detecting potion 33 checks as to whether the counted value issued from the pulse counter 31 is not less than the standard value or not in a predetermined time (S103). The synchronization detecting potion 33 detects the presence or absence of synchronization based on the counted value issued from the pulse counter 31, and transmits a detection signal representing the absence of synchronization to the channel selecting portion 32 if the counted value is not more than the standard value.

The channel selecting portion 32 adds a predetermined frequency to and subtracts the predetermined frequency from the central frequency upon reception of the detection signal representing the absence of synchronization (S104), and the channel selecting portion 32 transmits the corrected frequency data again to the tuner 10. The frequency data is corrected until the counted value of the pulse counter 31 exceeds the standard value.

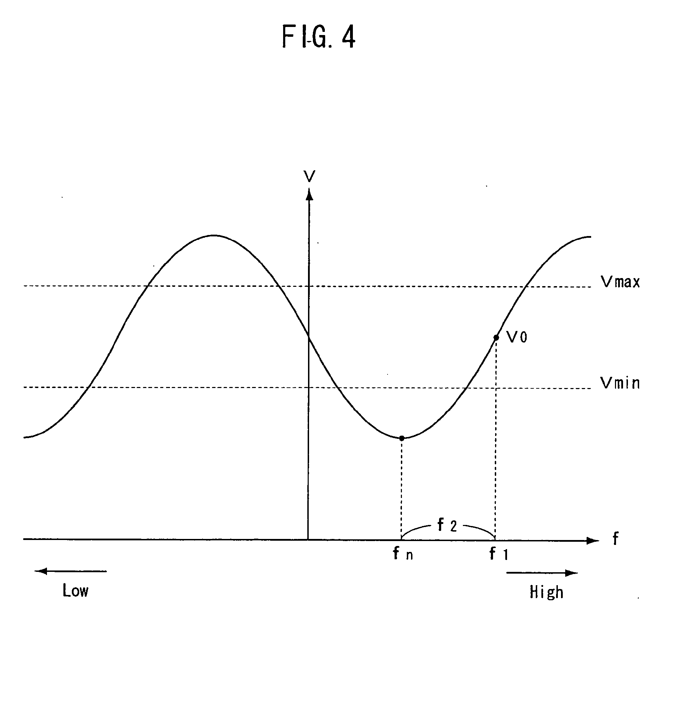

When the detection signal representing the presence of synchronization is transmitted from the synchronization detecting potion 33 to the channel selecting portion 32, the channel selecting portion 32 receives data relating to the AFT voltage of the VIF circuit 11 from the AFT voltage detecting portion 30 (S105). Then, the channel selecting portion 32 checks as to whether the AFT voltage value falls within a predetermined range (S106). Fig. 4 is a graph showing a relationship between the AFT voltage and the frequency wherein a horizontal axis shows the frequency while the vertical axis shows the AFT voltage. The AFT voltage varies so as to draw a sine wave relative to the frequency, however the graph shows a part of the sine wave. When the channel selecting operation is implemented, the AFT voltage is set, as shown in Fig. 4, between the upper limit voltage Vmax (3.06V) and the lower limit voltage Vmin (2.69V). Accordingly, in step S106, it is checked as to whether the AFT voltage falls within the range defined by the upper limit voltage Vmax and the lower limit voltage Vmin, and if the AFT voltage falls beyond this range, the frequency data is corrected in step S104, then the tuning operation is controlled again.

If it is decided that the AFT voltage from the AFT voltage detecting portion 30 falls within a predetermined range upon reception of the detection signal representing the presence of synchronization from the synchronization detecting potion 33, the channel selecting portion 32 transmits the tuning frequency data f₁ and an AFT voltage value V₀ at the time of decision to the processing portion 34, and the processing portion 34 allows the tuning frequency data f₁ and the AFT voltage value V₀ to be stored in the storage portion 4 together with a channel number (S107).

The channel number obtained by tuning the frequency while the above-mentioned preset operation is repeated for every channel, and the tuning frequency data f₁ and the AFT voltage value V₀ corresponding to the channel number are all stored in the storage portion 4. The preset operation is implemented by use of the tuner 10 alone but not implemented by use of the tuner 20.

Described next are cases where a channel is switched. That is, there are a case where a channel is switched when a TV broadcast program is displayed by use of the tuner 10, and a case where the TV broadcast program is displayed by switching the tuner 20 to a channel which is different from a channel where a picture is recorded during the picture recording in the picture recording and playback portion 1.

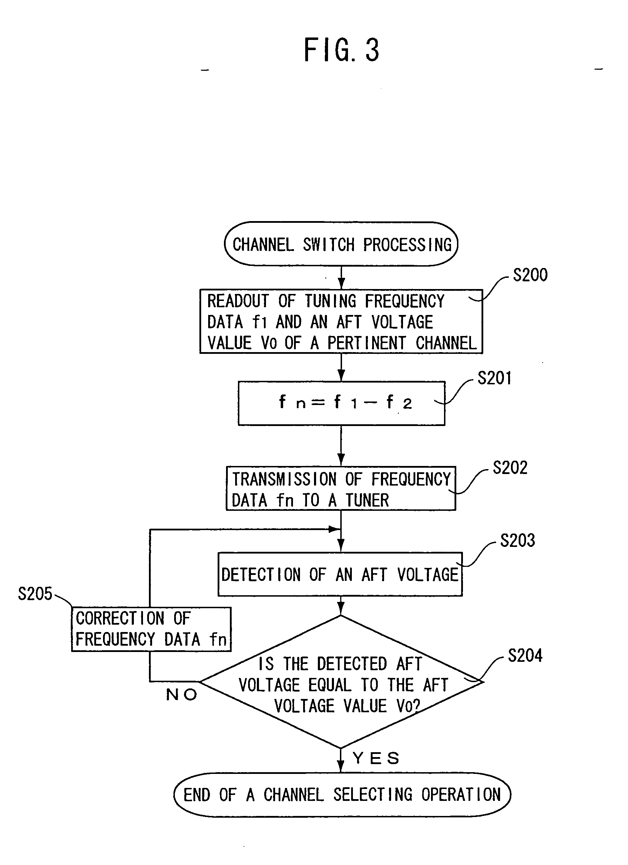

The channel switching operation is implemented by an operator who selectively operate the channel using the remote controller 8, and the operation signal is transmitted to the operation information input portion 7. The operation signal received by the operation information input portion 7 is transmitted to the processing portion 34 after the selected channel information is decided in a channel decision portion 35. Fig. 3 is a flowchart showing processes in a channel switch processing which is implemented based on the channel information. The processing portion 34 reads out the tuning frequency data f₁ and the AFT voltage value V₀ corresponding to the channel information from the storage portion 4 (S200). The tuning frequency data f₁ and the AFT voltage value V₀ thus read out by the processing portion 34 are transmitted to the channel selecting portion 32, where a frequency data fₙ is calculated by subtracting a predetermined frequency f₂ from the tuning frequency data f₁ (S201).

The tuning instruction signal is transmitted to the tuner 20 based on the calculated frequency data fₙ. The AFT voltage outputted from the VIF circuit 21 is detected by the AFT voltage detecting portion 30 by implementing the tuning operation in the tuner 20 (S203). Then it is checked as to whether the AFT voltage is equal to the AFT voltage value V₀ or not (S204). If the tuning operation is started with the frequency data fₙ in the tuner 20, since the frequency data fₙ is smaller than the tuning frequency data f₁ owing to the existence of the relationship between the AFT voltage and the frequency as shown in Fig. 4, the AFT voltage is detected to be smaller than the AFT voltage value V₀. Then the tuning operation is implemented by the tuner 20 while the frequency data fₙ is increased so as to allow the detected AFT voltage to approach the AFT voltage value V₀, and it is considered that synchronization is effected at the time when the detected AFT voltage is equal to the AFT voltage value V₀, thereby ending the channel selecting operation.

In such a manner, when the tuning operation is started with the frequency data fₙ, which is obtained by subtracting the predetermined frequency f₂ from the tuning frequency data f₁, there frequently occurs a case where the frequency is deviated to a smaller one even if there is a deviation between the tuning frequency data f₁ and the actual tuning frequency, thereby implementing the channel selection while the tuning operation is reliably implemented. It is preferable that the predetermined frequency f₂ is set at a value not more than 2 MHz which is a range where the deviation of the AFT voltage can be corrected.

Accordingly, since the channel switch processing of the tuner 20 can be implemented without detecting synchronization, the processing can be simplified and implemented in a short time and also the channel selecting operation can be reliably implemented. According to the examples as explained above, although the tuning operation is started with the frequency data fₙ obtained by subtracting the predetermined frequency f₂ from the tuning frequency data f₁, the turning operation may be implemented using the tuning frequency data f₁ as it is. In this case, the processing can be further simplified.

Further, according to the examples as explained above, although the channel switch processing can be implemented by the tuner 20, the channel switch processing of the tuner 10 can be likewise implemented in a short time by use of the tuning frequency data f₁ and the AFT voltage value V₀ which are stored by the preset operation.

The disclosure of Japanese Patent Application No. 2003-400992 including specification, claims, and drawings, is incorporated herein by reference.
The features disclosed in the foregoing description, in the claims and / or in the accompanying drawings may, both separately and in any combination thereof, be material for realising the invention in diverse forms thereof.

## Claims

1. A channel selecting unit comprising:
a tuner 10 for outputting an intermediate frequency based on a tuning instruction signal corresponding to a channel;
a VIF circuit 11 for amplifying the intermediate frequency signal outputted from the tuner 10 and outputting an AFT voltage;
a video signal processing circuit 12, 13 for separating a synchronous signal from the amplified intermediately frequency signal outputted from the VIF circuit 11 and outputting the synchronous signal; and
a control circuit 3 for outputting the tuning instruction signal to the tuner 10 and subjecting the tuner to an AFT control based on the AFT voltage;
wherein the control circuit 3 is comprised of synchronization detecting means 33 for detecting the presence or absence of synchronization based on the synchronous signal, storage means 4 for storing therein tuning frequency data f₁ and an AFT voltage value V₀ for every channel when the synchronization detecting means 33 detects the presence of synchronization and the AFT voltage falling within a predetermined range, and channel select control means 32, 34 for reading out the tuning frequency data f₁ and the AFT voltage value V₀ of a pertinent turner from the storage means 4 based on a channel switching signal, thereby implementing a channel selecting operation.

2. A channel selecting unit comprising:
a plurality of tuners 10, 20 each outputting an intermediate frequency based on a tuning instruction signal corresponding to a channel;
a plurality of VIF circuits 11, 21 each amplifying an intermediate frequency signal outputted from each tuner 10, 20 and outputting an AFT voltage;
a video signal processing circuit 12, 13 for separating a synchronous signal from the amplified intermediate frequency signal outputted from each VIF circuit11, 21 and outputting the synchronous signal; and
a control circuit 3 for outputting the tuning instruction signal to each tuner 10, 20 and subjecting each tuner 10, 20 to an AFT control based on the AFT voltage;
wherein the control circuit 3 is comprised of synchronization detecting means 33 for detecting the presence or absence of synchronization based on the synchronous signal which is separated from the intermediate frequency signal outputted from a specified tuner, storage means 4 for storing therein tuning frequency data f₁ and an AFT voltage value V₀ for every channel when the synchronization detecting means 33 detects the presence of synchronization and the AFT voltage falling within a predetermined range, and channel select control means 32, 34 for reading out the tuning frequency data f₁ and the AFT voltage value V₀ of the pertinent tuner from the storage means 4 based on a channel switching signal relating to a tuner other than the specified tuner, thereby implementing a channel selecting operation.

3. A channel selecting unit according to Claim 2, wherein the specified tuner is a tuner for recording picture.

4. A channel selecting unit according to any of Claim 1 or 2, wherein the channel select control means 32, 34 implements the channel selecting operation until the AFT voltage reaches a predetermined range by controlling the frequency in such a manner that it gradually increases the frequency beginning with frequency data which is lower than the tuning frequency data read out from the storage means 4 by a predetermined frequency.
